Europäisches Patentamt

European Patent Office

Office européen des brevets

(11) Veröffentlichungsnummer: **0 418 477 A2**

# EUROPÄISCHE PATENTANMELDUNG

(21) Anmeldenummer: 90111156.7

(51) Int. Cl.⁵: **G01R 31/02**

(22) Anmeldetag: 13.06.90

(30) Priorität: 21.09.89 DE 3931495

(43) Veröffentlichungstag der Anmeldung:
27.03.91 Patentblatt 91/13

(84) Benannte Vertragsstaaten:
**DE FR GB IT NL**

(71) Anmelder: **Deutsche ITT Industries GmbH**
**Hans-Bunte-Strasse 19 Postfach 840**
**W-7800 Freiburg i.Br.(DE)**

(72) Erfinder: **Paschke, Klaus**
**Habsburgerstrasse 24**
**W-7832 Kenzingen(DE)**
Erfinder: **Zipfel, Roland**
**Oberer Kirchweg 11**
**W-7800 Freiburg-Tiengen(DE)**

(54) Verfahren zur "fliessenden" Feinklassifizierung von Kapazitätsdioden.

(57) Die Erfindung betrifft ein Verfahren, das die "fließende" Feinklassifizierung von Kapazitätsdioden ermöglicht, wobei deren Einzelkristalle von der Siliziumscheibe mäanderförmig abgenommen, auf einem Montageband befestigt und gebondet sowie nach dem Verkapseln vereinzelt und gemessen werden.

EP 0 418 477 A2

## VERFAHREN ZUR "FLIESSENDEN" FEINKLASSIFIZIERUNG VON KAPAZITÄTSDIODEN

Die Erfindung betrifft ein Verfahren, das auf einfache Weise die Feinklassifizierung von Kapazitätsdioden, also das Zusammenfassen von Kapazitätsdioden gleicher Parameter innerhalb enger Toleranzgrenzen, ermöglicht.

Durch physikalische Streuungen bei der Herstellung sowohl der Siliziumscheiben (Wafer) wie der eigentlichen Herstellung der Kapazitätsdioden auf den Siliziumscheiben ist es unvermeidlich, daß durch den Prozeßablauf bedingt die einzelnen Kapazitätsdioden, nachfolgend stets nur als Dioden bezeichnet, abweichende elektrische Parameter und damit auch verschiedene C/U-Kennlinien aufweisen.

Die Weiterverarbeitung der auf einer Siliziumscheibe erzeugten Dioden besteht üblicherweise darin, die Scheibe einseitig mit einer Folie zu überziehen und in die Einzelkristalle zu zerteilen, die dann nach Ablösen der Folie als Schüttgut anfallen. Durch entsprechende Einordnungs- und Montagevorgänge werden die Kristalle in der nächsten Verarbeitungsstufe z.B. als Glasdioden verkapselt.

Um nun aus der Masse von Einzeldioden mit unterschiedlichen Parametern die bezüglich der C/U-Kennlinien zueinander passenden Dioden herauszufinden, wie es z.B. für die Herstellung von Fernsehtunern unumgänglich ist, wo üblicherweise zwischen 4 bis 8 derartig zusammenpassende Dioden benötigt werden, sind aufwendige Meß- und Sortiervorgänge notwendig.

Da es nicht möglich ist, ein entsprechendes Meßprogramm für Tausende von Feingruppen zu erstellen, ist man gezwungen, sich z.B. auf statistische, in Vorversuchen ermittelte, zirka 80 stärkste Belegungsgruppen zu beschränken. Auch diese erfordern noch einen erheblichen Aufwand an Gerät und Zeit. Die Toleranzbreite zwischen den Bauelementen einer Gruppe liegt dabei in typischer Weise bei 2.5%. Die mengenmäßige Verteilung auf einzelne Gruppen ist dabei sehr unterschiedlich, so daß zum Anhäufen einer sinnvollen Stückzahl pro Feingruppe ein erhebliches Volumen an Schüttgut erforderlich ist und die Zahl der gleichartigen Dioden einer Gruppe unter Umständen nur langsam anwächst. Zurück bleibt außerdem stets ein erheblicher Bodensatz, der in keine Gruppe hineinpaßt, und der einer neuen Charge von aufzuteilenden Dioden zugeführt wird. Zwangsläufig wächst dabei von Charge zu Charge der Anteil an nicht geeigneten, also nicht "zueinander passenden Dioden", die letzlich verworfen werden müssen.

Die Erfindung löst somit die Aufgabe, ein Verfahren anzugeben, das eine einfachere und wirtschaftlichere Feinklassifizierung von Dioden mit gleichen elektrischen Parametern ermöglicht.

Die Erfindung geht dabei von der Erkenntnis aus, daß unmittelbar benachbarte Diodenkristalle auf einer Siliziumscheibe einen angenähert gleichen C/U-Kennlinienverlauf besitzen, obwohl über die gesamte Siliziumscheibe aus Gründen von Fertigungsstreuungen in den Diffusionsprozessen, besonders in der vertikalen Richtung, ein erheblicher Temperaturgradient bei der C/U-Kennlinie auftritt. Bei den bislang angewendeten Verfahren zur Klassifizierung von fertig aufgebauten Dioden konnte die oben erwähnte Ähnlichkeit systembedingt nicht ausgenutzt werden.

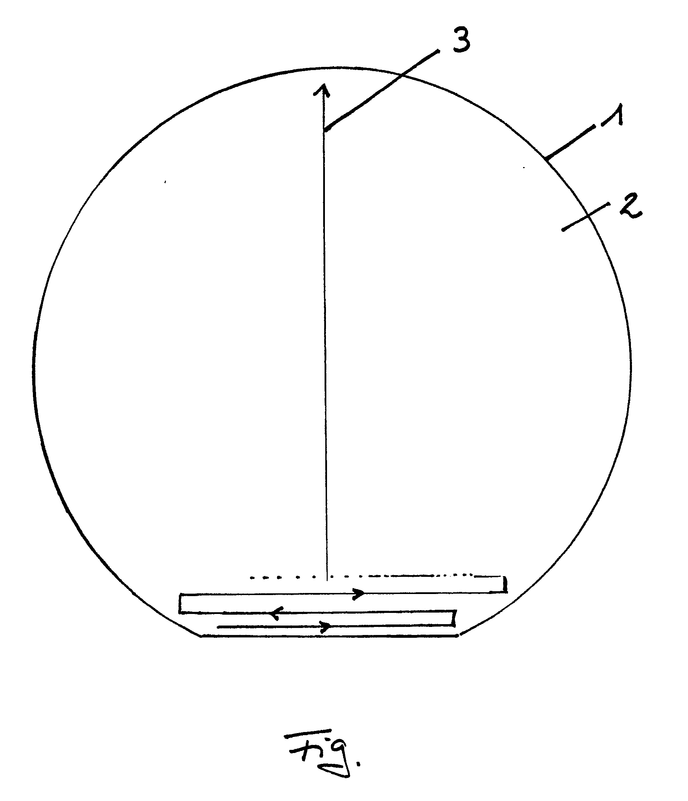

Die Erfindung wird nachstehend anhand der beigefügten Figur erläutert, die schematisch eine Siliziumscheibe 1 mit einer darauf nach herkömmlicher Art erzeugten Vielzahl von Diodenkristallen 2 darstellt. Der senkrecht verlaufende Pfeil 3 zeigt die Richtung des Temperaturgradienten der C/U-Kennlinie der einzelnen Diodenkristalle an. Beim Verfahren nach der Erfindung werden die Einzelkristalle nach dem Zertrennen der Siliziumscheibe 1 nicht mehr in ungeordnetes Schüttgut übergeführt, sondern von einem Greifarm mäanderförmig im rechten Winkel zum Temperaturgradienten auf der Siliziumscheibe 1 abgenommen. Der Startpunkt ist dabei beliebig, d.h. der Greifarm kann am Rande der Scheibe entweder in der Figur unten oder oben mit dem ersten Abnahmeschritt beginnen.

Die mäanderförmige Abnahme folgt den Weg des geringsten Unterschieds im Temperaturgradienten und man erhält dadurch die sich bezüglich ihrer C/U-Kennlinie am nächsten kommenden Diodenkristalle nach der erfindungsgemäßen Weiterbehandlung in Serie auf dem herkömmlichen Transportgurt. Außerdem findet ein Kristall bei Störung nach einer bestimmten Schrittfolge wieder einen passenden Nachbarn. Die abgenommenen einzelnen Diodenkristalle 2 werden auf ein entsprechendes Montageband aufgesetzt und dort durch z.B. Legieren befestigt.

Im nächsten Schritt wird dann der zweite Kontakt über einen Bonddraht hergestellt und nach einem ersten Versiegeln mit Kunstharzpulver das Montageband mit den darauf angeordneten Diodenkristallen der Verkapselung, z.B. der Kunstharzumspritzung, zugeführt. Das Band mit den verkapselten Dioden wird danach verzinnt und gelangt zur letzten Fertigungsstelle, wo die Trennung und Klassifizierung erfolgt.

Als erster Schritt werden dabei dort in einem Stanzvorgang am Montageband die Zwischenstege entfernt, so daß die Dioden nur noch mit ihren beiden Anschlußdrähten von den verbliebenen Seitenstegen des Montagebandes gehalten werden.

Im nächsten Schritt werden die Haltestege entfernt und die einzelnen Dioden getaktet von den entsprechenden Klemmvorrichtungen eines Meßrades erfaßt. Die vereinzelten Dioden werden dann schrittweise von dem Meßrad an einer der den zu messenden Parametern entsprechenden Zahl von Meßstellen vorbeigeführt, ihre Meßwerte von einem Rechner erfaßt und ausgewertet und dabei diejenigen aussortiert, die außerhalb der vorgegebenen Toleranzgrenze liegen. Die "brauchbaren" Dioden werden von dem Meßrad abgenommen und auf ein Pufferrad überführt. Dort werden sie gespeichert, bis eine Stückzahl von z.B. 10 passenden Dioden zusammen sind, die dann von dem Rad in die Taschen eines der üblichen Transportgurte (Blistergurte) eingelegt werden. Weicht nun bei den 10 Dioden eine nach unten oder oben zu stark von dem Mittelwert ab, so wird diese Diode aussortiert, um die Feinklassifizierungsausbeute zu erhöhen. Auf dem Blistergurt sind die Dioden also "fließend" feinklassifiziert, d.h. an jeder Stelle des Gurtes liegen immer die 10 benachbarten Dioden innerhalb der vorgegebenen Streubreite.

Das erfindungsgemäße Verfahren ermöglicht es, ca. 90% der Dioden einer Siliziumscheibe in einer "fließenden" Feinklassifizierung zu erfassen. Ein sogenanntes Diodenquartett weist dann eine typische Streubreite von nur 0,4% auf. Damit verringern sich für den Anwender der Abgleichaufwand, was erhebliche Einsparungen auf der Kostenseite bedeutet.

## Ansprüche

1. Verfahren zur "fließenden" Feinklassifizierung von Kapazitätsdioden gleicher elektrischer Parameter, wobei
- die auf einer Siliziumscheibe (1) gebildeten und nach dem Zertrennen derselben von einer Folie gehaltenen Einzelkristalle (2) zur Herstellung der Dioden mäanderförmig abgehoben und auf einem Montageband befestigt, kontaktiert und mit Kunststoff umspritzt werden,
- das Montageband nach dem Verzinnen einer Stanzvorrichtung zugeführt wird, in der seine Zwischenstege entfernt werden,
- das noch verbliebene Montageband aus den Längsstegen mit den dazwischen angeordneten Dioden und Anschlußdrähten einer zweiten Stanzvorrichtung zugeführt wird,
- die Dioden dort abgetrennt und jeweils von einer Klemmvorrichtung eines Meßrades erfaßt werden, das sie getaktet den einzelnen Meßstationen zur Bestimmung ihrer Parameter zuführt,
- die außerhalb der Toleranzgrenze liegenden Dioden eliminiert und die den Anforderungen entsprechen aufgenommen und über ein Pufferrad in den Transportgurt eingegeben werden.

2. Verfahren nach Anspruch 1, dadurch gekennzeichnet, daß die Diodenkristalle 2 im rechten Winkel zum Temperaturgradientenverlauf auf der Siliziumscheibe (1) mäanderförmig abgenommen werden.

3. Verfahren nach den vorhergehenden Ansprüchen, dadurch gekennzeichnet, daß die Diodenkristalle auf den Montageband aufliegert werden.

Fig.